# EUROPÄISCHE PATENTSCHRIFT

(11) **EP 0 676 619 B1**
(45) Veröffentlichungstag und Bekanntmachung des Hinweises auf die Patenterteilung: **22.03.2000**
(21) Anmeldenummer: 95250035.3
(22) Anmeldetag: 13.02.1995
(51) Int. Cl.: G01D 5/14, H02K 11/00, H01H 13/00

(54) **Tastelement für die Steuerung von Elektromotoren**
Push button for the control of electric motors
Bouton poussoir pour la commande de moteurs électriques

(30) Priorität: 11.04.1994 DE 4412555
(43) Veröffentlichungstag der Anmeldung: 11.10.1995
(73) Patentinhaber: MANNESMANN Aktiengesellschaft, 40213 Düsseldorf (DE)
(72) Erfinder: Hoppe, Kurt, D-58339 Breckerfeld (DE); Schmalstieg, Markus Hubert, D-58093 Hagen (DE); Stanski, Bernhard, D-45665 Recklinghausen (DE); Münzebrock, Anton, D-44139 Dortmund (DE)
(74) Vertreter: Presting, Hans-Joachim, Dipl.-Ing.

(56) Entgegenhaltungen:
- EP-A- 0 423 673
- US-A- 4 950 922
- PATENT ABSTRACTS OF JAPAN vol. 016 no. 288 (E-1223) ,25.Juni 1992 & JP-A-04 073907 (ISUZU SERAMITSUKUSU KENKIYUUSHIYO:KK) 9.März 1992,
- PATENT ABSTRACTS OF JAPAN vol. 013 no. 220 (E-762) ,23.Mai 1989 & JP-A-01 031482 (NIPPON MINING CO LTD) 1.Februar 1989,

## Beschreibung

Die Erfindung betrifft ein Tastelement für die Steuerung von Elektromotoren, insbesondere für Krane und andere Fördermittel, gemäß dem Oberbegriff des Anspruchs 1.

US-A-4 950 922 beschreibt ein Tastelement für die Steuerung von Elektromotoren mit einem das Steuersignal auslösenden Taststößel, der in einem Gehäuse verschiebbar gelagert ist. Ein am Tasterstößel befestigter Permanentmagnet ist im wesentlichen senkrecht gegen die aktive Fläche eines Hall-Sensors anstellbar und einpolig axial auf die aktive Fläche des Hall-Sensors annäherbar bzw. wieder wegbewegbar. Im Gehäuse ist eine den Hall-Sensor umfassende elektronische Schaltung integriert.

Aus der EP 0423673 A1 ist ein Tastelement für die Steuerung von Elektromotoren bekannt, mit einem das Steuersignal auslösenden Tasterstößel, der in einem Gehäuse verschiebbar gelagert ist, und wobei eine elektronische Schaltung vorgesehen ist, die einen gegen einen Hall- Sensor anstellbaren Permanent-Magneten umfaßt und in das Tastelement-Gehäuse integriert ist.

Der nach seinem Entdecker E. Hall benannte Effekt und den damit zusammenhängenden magnetoresistiven Effekt bildet die physikalische Grundlage für Hall- und Feldplatten-Sensoren: Bewegte Ladungsträger werden unter Einwirkung eines senkrechten Magnetfeldes B durch die Lorentz-Kraft seitlich abgelenkt. Durch das entstehende Querfeld in der Mitte des Halbleiterplättchens stellt sich ein Gleichgewichtszustand ein.

Die Hall-Spannung UH ist proportional zum Magnetfeld B und zum Steuerstrom i und umgekehrt proportional zur Schichtdicke d und zur Ladungskonzentration n. RH wird als Hall-Konstante bezeichnet. Betrachtet man die Strombahnen, so sind diese im Nahbereich der Stromelektroden ebenfalls um den Hall-Winkel gedreht. Man erhält für kleine Hall-Winkel (gleich oder kleiner 0,45) eine quadratische Abhängigkeit des Widerstandes vom Magnetfeld B. R₀ ist der Widerstand ohne Magnetfeld.

Hall-Sensoren sind demnach aktive Vierpole mit einem Strom- und Hall-Spannungspfad, während Feldplatten passive magnetfeldabhängige Widerstände darstellen.

Alle Magnetfeldsensoren, die nicht zum direkten Messen von Magnetfeldern eingesetzt werden, benutzen das Magnetfeld als Übertragungsmedium zwischen einer zu erfassenden physikalischen Größe (Position, Drehzahl, Strom, Leistung u.dgl.) und dem Sensor. Das richtige Design des Magnetkreises ist somit Voraussetzung für die volle Nutzung der Sensoreigenschaften. Man unterscheidet je nach Scherung einen offenen (stark geschert) und einem geschlossenen Magnetkreis.

Der einfachste Magnetkreis besteht aus einem Permanent-Magneten und einem Sensor. Vorbeibewegte weichmagnetische Teile führen zu einer Induktionsänderung, die vom Sensor erfaßt wird.

Beim Aufbau des Sensors und bei der Wahl des Luftspaltes Sensor/Indikator ist besonders der starke Abfall der magnetischen Induktion bei zunehmendem Abstand von der Bodenfläche des Magneten zu berücksichtigen.

Ein mit einem Permanent-Magneten erregter geschlossener Magnetkreis wird zur Positionserfassung häufig als Magnetgabelschranke ausgeführt. Geschlossene Magnetkreise mit elektrischer Erregung bilden die Basis für potentialfreie Strom- und Leistungsmessung. Die von dem zu messenden Strom erzeugte Erregung liefert eine Induktion, die von einem Hall-Sensor im Luftspalt gemessen wird. Es ergibt sich ein linearer Zusammenhang zwischen Meßstrom und Induktion.

Bei dieser analogen Anwendung werden hohe Anforderungen an das Design des Magnetkreises gestellt: Hohe Permeabilität, große lineare Aussteuerbarkeit, kleine Remanenz, kleiner Luftspalt, um nur einige zu nennen.

In der Meß-, Steuer- und Regeltechnik dienen Positionssensoren zur berührungslosen und damit verschleißfreien Erfassung von Steuerungsparametern, wie Weg, Winkel und Drehzahl. Für diese Aufgabe eignen sich besonders Hall-Sensoren.

Hall-Sensoren sind Halbleiterbauelemente, deren elektrisches Verhalten durch Magnetfelder beeinflußt werden können. Die Basis ist der erwähnte Hall-Effekt. Man beobachtet ihn in stromdurchflossenen bandförmigen Leitern, die einem transversalen Magnetfeld ausgesetzt sind. Das Magnetfeld bewirkt, daß die das Blättchen in Längsrichtung durchfließenden Elektronen zur Seite abgelenkt werden. An den Seitenkontakten läßt sich dann die Hall-Spannung abgreifen. Diese Hall-Spannung ist nicht nur von der Größe des Stromes und der magnetischen Induktion abhängig, sondern vor allem von der Geschwindigkeit, mit der die Elektronen den bandförmigen Leiter durchfließen. In Metallen bewirken viele langsame Elektronen den Stromfluß, und die Hall-Spannung ist kaum meßbar klein. Sehr groß dagegen ist der Hall-Effekt in bestimmten Halbleitermaterialien, bei denen der Strom von wenigen Elektronen hoher Geschwindigkeit getragen ist.

Bauelemente, die auf diesem Effekt beruhen, liefern ein elektrische Signal, wenn ein Magnetfeld auf sie wirkt. Sind sie mit einem Permanentmagneten verbunden, so ändert sich ihre Hall-Spannung beim Annähern eines weichmagnetischen Körpers, der das vorhandene Magnetfeld beeinflußt. Im Vergleich mit induktiven Gebern haben sie den Vorteil, daß ihre Signalspannung unabhängig davon ist, mit welcher Geschwindigkeit der zu registrierende Körper sich dem Sensor nähert. Entsprechend den unterschiedlichen Anforderungen an die Sensoren werden verschiedene Ausführungsformen angeboten.

Tastelemente für die Steuerung von Elektromotoren mit mehreren Geschwindigkeiten sollen vom Betätigungsweg abhängig eine größere oder kleinere Geschwindigkeit vorgeben. Das wird z.B. dadurch erreicht, daß der Tasterstößel auf einem Weg mehrere Kontakte in Folge schließt, mit denen zugeordnete Geschwindigkeitsstufen vorgegeben werden. Um die Geschwindigkeit stufenlos zu steuern, bewegt z.B. der Taster einen Schleifer auf einer Widerstandsbahn. Der entlang des Stößelweges angegriffene veränderliche elektrische Widerstand gibt dann wegabhängig eine Geschwindigkeit vor. Beide Lösungen sind verschleißbehaftet, weil der Tasterweg durch Kontaktberührungen in elektrische Steuersignale umgesetzt wird. Vorteilhaft, da verschleißfrei, wäre die berührungslose Positionsmessung für die Steuerung der Geschwindigkeit mit einem Tastelement.

Ein Tastelement für die Steuerung von Elektromotoren sollte weiterhin in seiner Baugröße nur von einer solchen äußeren Abmessung sein, daß es in anderen Einrichtungen, wie z.B. einem Handschalter u.dgl. Platz findet.

Der vorliegenden Erfindung liegt daher die Aufgabe zugrunde, ein Tastelement für die Steuerung von Elektromotoren in der Art der berührungslosen Positionsmessung mit Hall-Sensoren zu schaffen, das in einer Vielzahl von anderen Schaltgeräten angeordnet werden kann.

Die gestellte Aufgabe wird erfindungsgemäß mit den Merkmalen des Patentanspruchs 1 gelöst.

Es ist von Vorteil, daß der Permanent-Magnet an dem Tasterstößel justierbar befestigt ist. Zum Abgleich auf den Anfangs- bzw. Endwert benötigt man den Widerstand R₄. Es kann dabei gezeigt werden, inwieweit sich der Kurvenverlauf ändert, wenn der Widerstand R₄ verstellt wird. Im beschriebenen Fall geschieht dies mit einer Widerstandsdekade. Aus der beigefügten Tabelle und der Zeichnung kann man erkennen, daß die Kurve eine flache Steigung im Anfangsbereich aufweist und den Endwert nur knapp erreicht, wenn der Widerstand kleiner als 22 k Ohm wird. Anders ist es, wenn man den Widerstand auf 22,6 k Ohm einstellt. Hier ist die Steigung zunächst steil und die Kurve vom gesamten Verlauf her fast optimal.

Weitere Erfindungsmerkmale bestehen darin, daß der Permanent-Magnet aus Samarium-Cobalt und Neodym-Eisen-Bor besteht. Diese Materialien zeichnen sich durch eine hohe Energiedichte bei kleinen Volumina aus.

Eine weitere Verbesserung der Erfindung ist dadurch gegeben, daß der Hall-Sensor aus Galliumarsenit (GaAs) besteht.

Ein Ausführungsbeispiel der Erfindung ist in der Zeichnung dargestellt und wird im folgenden näher beschrieben. Es zeigen:
- Fig. 1: eine in einem Gehäuse integrierte elektronische Schaltung,
- Fig. 2A: die Ergebnisse einer ersten Meßreihe als Tabelle,
- Fig. 2B: das zu Fig. 2a gehörige Diagramm,
- Fig. 3A: die Ergebnisse einer zweiten Meßreihe, ebenfalls in Tabellenform und
- Fig. 3B: das zu Fig. 3A gehörige Diagramm.

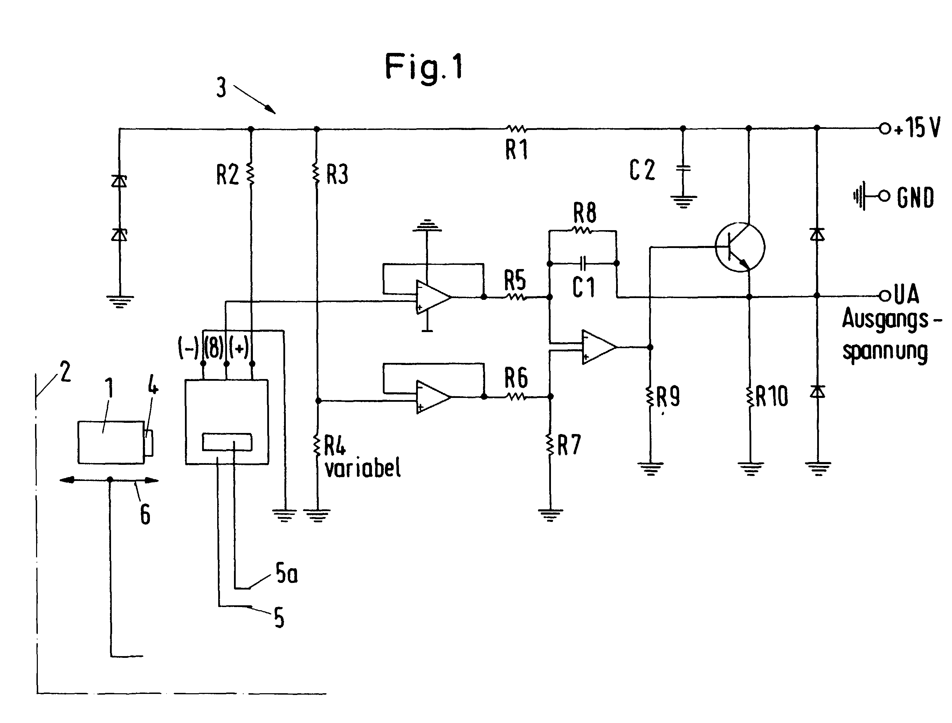

Fig. 1 zeigt eine Schaltung, die für die Positionsmessung mit einem Hall-Sensor dient. Ein Tasterstößel 1 ist in einem Gehäuse 2 bewegbar.

Der Tasterstößel 1 trägt einen Permanent-Magneten 4. Ein Hall-Sensor 5 besitzt eine aktive Fläche 5a, und der Tasterstößel 1 wird senkrecht zur aktiven Fläche 5a in Bewegungsrichtung 6 hin- und herbewegt. Die Rückbewegung erfolgt dabei durch eine nicht näher dargestellte Rückstellfeder.

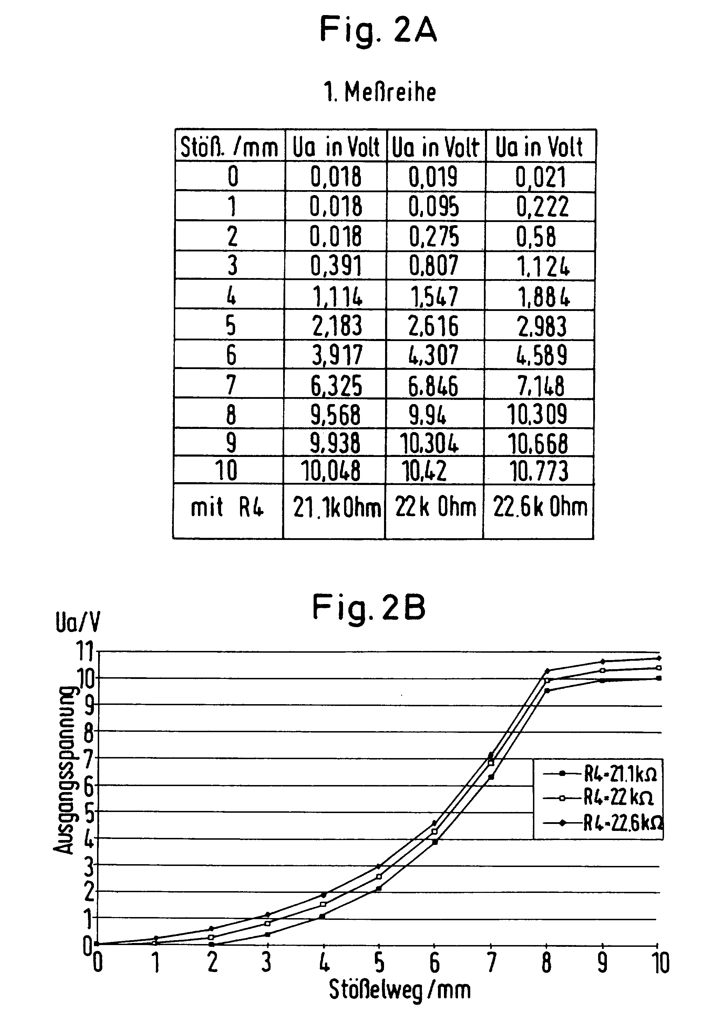

Gemäß Fig. 2A wird gezeigt, inwieweit sich der Kurvenverlauf ändert, wenn ein widerstand R₄ verstellt wird. Dies geschieht mit einer Widerstandsdekade. Fig. 2A und Fig. 2B zeigen sodann, daß die Kurve eine flache Steigung im Anfangsbereich aufweist und den Endwert nur knapp erreicht, wenn der Widerstand kleiner als 22 kOhm wird. Anders ist es, wenn man den widerstand auf 22,6 kOhm einstellt. Hier ist die Steigung zunächst steil und die Kurve vom gesamten Verlauf her optimal.

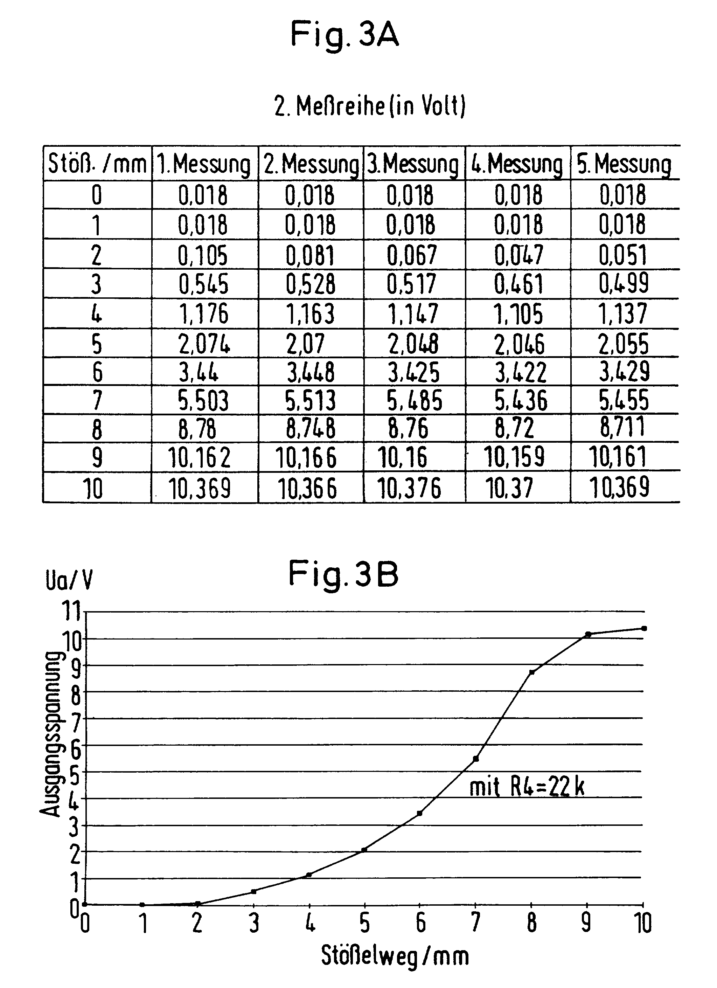

Gemäß den Meßwerten der Fig. 3A (zweite Meßreihe) wurde der Widerstand R₄ mit dem Wert 22 kOhm fest eingelötet, und danach konnte der Schalter wieder in die Meßvorrichtung eingespannt werden. Anschließend wurde der Tasterstößel 1 fünfmal im gleichen Abstand gedrückt, daraus der Mittelwert errechnet und in der Kennlinie dargestellt (Fig. 3B).

Bei den Messungen aufgrund der elektronischen Schaltung 3 mit dem Hall-Sensor 5 stellt sich der gewünschte Erfolg ein. Eine erste Vorgabe nach einem exponentiellen Kurvenverlauf, d.h. einer guten Regulierungsmöglichkeit der unteren Drehzahlen eines Elektromotors, wurde erfüllt. Außerdem bedeutet es kein Problem, mit dem Widerstand R₄ abzugleichen und gleichzeitig den Kurvenverlauf zu verändern. Es kann vorher festgelegt werden, welcher Kennlinienverlauf für den praktischen Fall geeignet ist. Ist z.B. die Steigung im Anfangsbereich wichtig oder aber das genaue Erreichen des Endwertes von 10 Volt, so kann der Kurvenverlauf entsprechend verändert werden. Die Auswirkungen der unterschiedlichen Widerstandsdimensionierungen von R₄ auf den Kennlinienverlauf wird bei der ersten Meßreihe (Fig. 2A) gezeigt. Eine besonders günstige Kurve ergibt sich mit dem Widerstand R₄ = 22,6 kOhm, weil diese Kurve die günstigste Steigung besitzt.

Der Schaltungsaufwand bei dem Tasterstößel 1 mit dem Hall-Sensor 5 ist relativ gering und preiswert, wobei die etwas höheren Kosten für den Hall-Sensor 5 und den Permanent-Magneten 4 nicht ins Gewicht fallen.

Es wird deutlich, daß die elektronische Schaltung 3 mit dem Hall-Sensor 5 und dem anstellbaren Permanent-Magneten 4 leicht in einem kleinstmöglichen Gehäuse untergebracht werden können.

### Bezugszeichenliste

- 1: Tasterstößel
- 2: Tastelement-Gehäuse
- 3: elektronische Schaltung
- 4: Permanent-Magnet
- 5: Hall-Sensor
- 5a: aktive Fläche
- 6: Bewegungsrichtung

## Patentansprüche

1. Tastelement für die Steuerung von Elektromotoren, insbesondere für Krane und andere Fördermittel,
mit einem das Steuersignal auslösenden Tasterstößel (1), der in einem Gehäuse (2) verschiebbar gelagert ist,
mit einem an dem Tasterstößel (1) befestigten Permanent-Magneten (4), der im wesentlichen senkrecht gegen die aktive Fläche eines Hall-Sensors (5) anstellbar und einpolig axial auf die aktive Fläche des Hall-Sensors (5) annäherbar bzw. wieder wegbewegbar ist, und mit einer in das Gehäuse (2) integrierten, den Hall-Sensor (5), umfassenden elektronischen Schaltung (3),
dadurch gekennzeichnet,
daß die elektronische Schaltung (3) als Ausgangsspannung Ua eine Differenzspannung abgibt, die aus der hyperbolisch verlaufenden Ausgangsspannung des Hall-Sensors (5) und einer Konstantspannung gebildet ist und deren Kurvenverlauf durch Einstellung der Konstantspannung über die Wegstrecke des Tasterstößels (1) an eine exponentielle Kurve angenähert ist.

2. Tastelement nach Anspruch 1,
dadruch gekennzeichnet,
daß der Permanent-Magnet (4) an dem Tasterstößel (1) justierbar befestigt ist.

3. Tastelement nach einem der Ansprüche 1 und 2,
dadurch gekennzeichnet,
daß der Permanent-Magnet (4) aus Samarium-Cobalt oder aus Neodym-Eisen-Bor besteht.

4. Tastelement nach einem der Ansprüche 1 bis 3,
dadurch gekennzeichnet,
daß der Hall-Sensor (5) aus Galliumarsenit besteht.

## Claims

1. Pushbutton control element for controlling electric motors, in particular for cranes and other conveying means, having a pushbutton control switch pushrod (1), which is displaceably mounted in a housing, having a permanent magnet (4) which is fixed to the pushbutton control switch pushrod (1) and which can be applied substantially perpendicularly against the active surface of a Hall sensor (5) and can be brought near to and moved away again from the active surface of a Hall sensor (5) axially with one pole, and having an electronic circuit (3) comprising the Hall sensor (5) and integrated in the housing, characterised in that the electronic circuit (3) transmits as an output voltage Ua a differential voltage, which is formed from the hyperbolic output voltage of the Hall sensor (5) and a constant voltage, and its curve approximates to an exponential curve over the path distance of the pushbutton control switch pushrod (1) by setting of the constant voltage.

2. Pushbutton control element according to claim 1, characterised in that the permanent magnet (4) is fixed adjustably to the pushbutton control switch pushrod (1).

3. Pushbutton control element according to one of claims 1 and 2, characterised in that the permanent magnet (4) consists of samarium-cobalt or ofneodymium-iron-boron.

4. Pushbutton control element according to one of claims 1 to 3, characterised in that the Hall sensor (5) consists of gallium arsenite.

## Revendications

1. Bouton-poussoir pour la commande de moteurs électriques, en particulier pour des grues et d'autres moyens de transport, comportant un poussoir (1) déclenchant le signal de commande, qui est monté de façon déplaçable dans un boîtier (2), un aimant permanent (4) fixé au poussoir (1), qui peut être appliqué de façon généralement perpendiculaire contre la surface active d'un capteur Hall (5) et peut être approché, de façon unipolaire, axialement sur la surface active du capteur Hall (5) ou en être à nouveau éloigné, et un circuit électronique (3), intégré dans le boîtier (2), comportant le capteur Hall (5),
caractérisé en ce que le circuit électronique (3) délivre, comme tension de sortie Ua, une tension différentielle qui est formée à partir de la tension de sortie hyperbolique du capteur Hall (5) et d'une tension constante, et dont l'allure de la courbe est approchée d'une courbe exponentielle par réglage de la tension constante sur la course du poussoir (1).

2. Bouton-poussoir selon la revendication 1,
caractérisé en ce que l'aimant permanent (4) est fixé de façon ajustable sur le poussoir (1).

3. Bouton-poussoir selon une des revendications 1 et 2,
caractérisé en ce que l'aimant permanent (4) est constitué de samariumcobalt ou de néodyme-fer-bore.

4. Bouton-poussoir selon une des revendications 1 à 3,
caractérisé en ce que le capteur Hall (5) est constitué d'arsénite de gallium.
